# EUROPEAN PATENT SPECIFICATION

(11) **EP 3 790 059 B1**
(45) Date of publication and mention of the grant of the patent: **13.08.2025**
(21) Application number: 19195484.1
(22) Date of filing: 05.09.2019
(51) Int. Cl.: H10F 19/80, H10F 19/90, H10F 77/00

(54) **METHODS FOR ELECTRICALLY CONTACTING AND INTERCONNECTING PHOTOVOLTAIC CELLS**
VERFAHREN ZUM ELEKTRISCHEN KONTAKTIEREN UND ZUR VERSCHALTUNG VON SOLARZELLEN
PROCÉDÉS DE MISE EN CONTACT ET D'INTERCONNEXION ÉLECTRIQUE DE CELLULES PHOTOVOLTAÏQUES

(43) Date of publication of application: 10.03.2021
(73) Proprietor: Imec VZW, 3001 Leuven (BE); Universiteit Hasselt, 3500 Hasselt (BE)
(72) Inventor: Borgers, Mr. Tom, 3001 Leuven (BE); Govaerts, Mr. Jonathan, 3001 Leuven (BE)
(74) Representative: Patent Department IMEC

(56) References cited:
- WO-A1-2013/066815
- WO-A1-2016/156276
- US-A- 5 474 620
- BORGERS TOM ET AL: "Multi-wire interconnection technologies weaving the way for back contact and bifacial PV modules", 2016 IEEE 43RD PHOTOVOLTAIC SPECIALISTS CONFERENCE (PVSC), IEEE, 5 June 2016 (2016-06-05), pages 3580 - 3583, XP033008336, DOI: 10.1109/PVSC.2016.7750339

## Description

### Field

The present invention relates to methods for electrically contacting photovoltaic cells and to methods for electrically interconnecting photovoltaic cells.

More in particular, the present invention relates to methods for electrically contacting and/or electrically interconnecting photovoltaic cells simultaneously with their encapsulation.

The present invention further relates to methods for fabricating photovoltaic modules.

### State of the art

In typical commercially available photovoltaic cells, an electrical current generated under illumination is collected at metal fingers that are electrically connected to a few, e.g. typically three, wider busbars. Tinned copper strips or ribbons, which may also be referred to as connectors or interconnectors, may be soldered to the busbars to electrically connect photovoltaic cells within a module. The size of the interconnectors is preferably limited to avoid excessive shadowing on the illuminated surface of the cells.

Methods are also known in the art for contacting and interconnecting busbar-free photovoltaic cells. In such methods, the metal fingers of the busbar-free photovoltaic cells may be contacted and connected by means of multiple electrically conductive wires. These electrically conductive wires may thus replace the busbars and the interconnectors. It is an advantage of such methods that a lower cost of photovoltaic modules can be achieved, e.g. due to a reduced silver consumption for the metallization and/or due to an increased module efficiency resulting from a lower series resistance and improved light harvesting.

The wires for contacting the busbar-free photovoltaic cells may for example be solder-coated copper wires, such that electrical contacts may be established between the wires and contact areas of the photovoltaic cell by heating and soldering. This approach may also be used for electrically connecting photovoltaic cells within a module. The wires may for example be attached to or integrated with an optically transparent foil, film or fabric before they are brought into contact with the photovoltaic cells.

In WO 2016/156276 A1, methods are described for electrically contacting and electrically interconnecting photovoltaic cells. The methods comprise providing a woven fabric comprising a plurality of electrically conductive wires being provided in a single one of a warp direction and a weft direction, the woven fabric further comprising a plurality of polymer yarns being provided in at least the other one of the warp direction and the weft direction. The woven fabric is brought into physical contact with a surface of a photovoltaic cell comprising a plurality of metal contacts, and afterwards a heating step is performed, thereby establishing an electrical connection between the respective metal contacts and at least one electrically conductive wire, and thereby liquefying the plurality of polymer yarns and transforming them into an encapsulation layer.

EP 3 258 503 A1 describes a method for contacting and electrically connecting back-contact photovoltaic cells comprising first metal contacts of a first polarity and second metal contacts of a second polarity on a single surface thereof. This method uses a woven fabric comprising a plurality of insulating ribbons arranged in a single one of a warp direction and a weft direction and a plurality of conductive wires arranged in at least a weft direction or a warp direction, wherein at least one of the plurality of conductive wires comprises at least a first segment and a second segment that are electrically isolated from each other. The woven fabric is brought into physical contact with the surface of the photovoltaic cells and a heating process is performed to establish an electrical connection between first metal contacts and first segments and between second metal contacts and second segments respectively. This heating process furthermore liquefies the plurality of insulating ribbons to transform them into an encapsulation layer.

It is an advantage of these woven fabric-based methods that the electrical contacts and electrical connections are formed simultaneously with the module encapsulation. Furthermore, the amount of encapsulation material contained in the woven fabric may be enough for the module lamination step. It is a further advantage that the electrically conductive wires are exposed at both sides of the fabric, such that they are connectable at both sides, resulting in an enhanced flexibility for contacting and interconnection, without the need for providing terminal bars or end ribbons.

However, it was found that in the woven fabric-based methods described above, the plurality of electrically conductive wires may move or shift during the heating process. In cases wherein good alignment between the electrically conductive wires and metal contacts of the photovoltaic cell is needed, this may result in poor alignment accuracy or misalignment problems. For example, in a method for contacting and electrically connecting back-contact photovoltaic cells comprising first metal contacts of a first polarity and second metal contacts of a second polarity on a single surface thereof, this may even lead to shorts between metal contacts of opposite polarities, resulting in non-working photovoltaic cells or modules.

It was further observed that in the woven fabric-based methods described above, solder material may flow along the electrically conductive wires during the heating process. This may lead to a reduced solder accumulation at the interface between electrically conductive wires and metal contacts of the photovoltaic cells, resulting in a poor quality of the electrical connections and to electrical reliability problems.

Hence, there is a need for methods that enable electrically contacting and/or electrically interconnecting photovoltaic cells and/or modules simultaneously with their encapsulation, with an improved alignment accuracy and with an improved electrical reliability.

### Summary

It is an objective of the present invention to provide methods for simultaneously electrically contacting and encapsulating photovoltaic cells by means of electrically conductive wires, wherein the methods enable a good alignment accuracy between the electrically conductive wires and metal contacts of the photovoltaic cells.

It is an objective of the present invention to provide methods for simultaneously electrically contacting and encapsulating photovoltaic cells by means of electrically conductive wires, wherein the methods provide an improved quality of the electrical contacts formed and an improved electrical reliability of the photovoltaic cells.

It is an objective of the present invention to provide methods for simultaneously electrically connecting and encapsulating a plurality of photovoltaic cells by means of electrically conductive wires, wherein the methods enable a good alignment accuracy between the electrically conductive wires and metal contacts of the photovoltaic cells.

It is an objective of the present invention to provide methods for simultaneously electrically connecting and encapsulating a plurality of photovoltaic cells by means of electrically conductive wires, wherein the methods provide an improved quality of the electrical connections formed and an improved electrical reliability of the photovoltaic cells.

It is an objective of the present invention to provide good and efficient methods for fabricating photovoltaic modules comprising a plurality of photovoltaic cells, wherein the methods provide a good quality of electrical contacts to and electrical connections between the photovoltaic cells and a good electrical reliability of the photovoltaic modules.

The above objectives are at least partially accomplished by a method according to the present invention, as defined in independent claim 1.

According to a first aspect, the invention is related to a method for electrically contacting at least one photovoltaic cell. A method for electrically contacting at least one photovoltaic cell comprising at least one metal contact, e.g. a plurality of metal contacts, at a surface of the at least one photovoltaic cell is provided, the method comprising: bringing a contact sheet comprising an electrically insulating encapsulant material and a plurality of electrically conductive wires covered by or coated with a solderable material into physical contact with the surface of the at least one photovoltaic cell; and covering the contact sheet with a carrier, at a side of the contact sheet opposite to the side where it is in contact with the surface of the at least one photovoltaic cell. The method further comprises performing a heating process, thereby establishing an electrical connection between at least one metal contact at the surface of the at least one photovoltaic cell and at least one electrically conductive wire of the contact sheet by soldering, liquefying the electrically insulating encapsulant material, attaching the carrier to the contact sheet by adhesion of the electrically insulating encapsulant material to the carrier and attaching the contact sheet to the surface of the at least one photovoltaic cell by adhesion of the electrically insulating encapsulant material to the surface of the at least one photovoltaic cell. As a result of the heating process a laminate is formed, the laminate comprising a stack comprising the at least one photovoltaic cell, the contact sheet and the carrier. In the method for electrically contacting at least one photovoltaic cell according to the first aspect of the present invention the contact sheet comprises a fiber material, the fiber material being incorporated between the at least one photovoltaic cell and the carrier. The electrically insulating encapsulant material is a thermoplastic material. In methods not part of the invention the electrically insulating encapsulant material may for example be a (partially) curing material, a thermosetting material or a combination of different materials.

In the context of the present invention, the term 'wire' refers to an elongate element that has a wire-like form or shape. For example, it may refer to a thread, a wire, a filament, a strand, a ribbon, a strip, a tape, a rod, a tubular structure or a similar elongate element.

In embodiments of the method according to the first aspect of the present invention, at least part of the plurality of electrically conductive wires is at least partially exposed at a surface of the contact sheet, preferably at both surfaces of the contact sheet.

In embodiments of the method according to the first aspect of the present invention a pressure may be applied during the heating process.

In embodiments of the method according to the first aspect of the present invention the heating process may comprise a first heating step at a first temperature, preferably lower than the melting temperature of the electrically insulating encapsulant material, and a second heating step at a second temperature, higher than the first temperature, preferably higher than the melting temperature of the electrically insulating encapsulant material. This is advantageous in that establishing the electrical connection between the at least one metal contact and the at least one electrically conductive wire can be done at a first temperature at which there is substantially no liquefication of the electrically insulating encapsulant material, resulting in a reduced risk of penetration of encapsulant material between the metal contacts and the electrically conductive wires, and thus a reduced risk of obtaining electrical connections of poor quality, e.g. having a high electrical resistance.

The method for electrically contacting at least one photovoltaic cell according to the first aspect of the present invention results in at least one encapsulated and contacted photovoltaic cell, at least one metal contact at the surface of the at least one photovoltaic cell being electrically connected to at least one electrically conductive wire of the contact sheet.

In the present invention the contact sheet comprises the fiber material, i.e. the fiber material is contained in the contact sheet. For example, the fiber material may be embedded in the electrically insulating encapsulant material. For example, the fiber material may be laminated with the electrically insulating encapsulant material.

It is an advantage of embodiments of the method of the first aspect of the present invention that the presence of the fiber material results in a reduced shifting of the plurality of electrically conductive wires during the heating process as compared to known methods, which may advantageously lead to an improved alignment between the electrically conductive wires of the contact sheet and the metal contacts at the surface of the at least one photovoltaic cell. The reduced shifting of the plurality of electrically conductive wires may be attributed to a reduction of the coefficient of thermal expansion of the encapsulant material with fiber material as compared to the same encapsulant material without such fiber material. The reduced coefficient of thermal expansion results in an improvement of the dimensional stability of the encapsulant material and a reduced flowing / expansion / shrinking of the encapsulant material during the heating process, advantageously leading to a reduced shifting of the electrically conductive wires.

It is additional advantage of the reduced coefficient of thermal expansion of the encapsulant material resulting from the presence of the fiber material that differences with the coefficient of thermal expansion of materials of the at least one photovoltaic cell (e.g. with the coefficient of thermal expansion of the active semiconductor material of the at least one photovoltaic cell) and differences with the coefficient of thermal expansion of other elements of the laminate, such as for example the coefficient of thermal expansion of the carrier, may be reduced. This advantageously leads to less stress and less strain on the electrical connections under temperature variations. Such temperature variations may for example occur during the fabrication process (e.g. during the heating process) or after fabrication, when the at least one photovoltaic cell is in operation. This reduction in stress and strain may further result in an improved electrical reliability of the at least one photovoltaic cells and of photovoltaic modules.

It is an advantage of embodiments of the method of the first aspect of the present invention that the fiber material may mechanically reinforce the laminate, thereby providing an improved mechanical strength and/or an improved resistance against mechanical damage.

In embodiments of the method of the first aspect of the present invention the electrically insulating encapsulant material may comprise, e.g. consist of, a plurality of electrically insulating wires. The plurality of electrically insulating wires of the encapsulant material may be interwoven with the plurality of electrically conductive wires.

In embodiments of the method of the first aspect of the present invention the electrically insulating encapsulant material may comprise, e.g. consist of, an encapsulant sheet, such as for example an encapsulant foil. In such embodiments the plurality of electrically conductive wires may be attached to or integrated with the encapsulant sheet, for example by printing, stitching, sewing or heating.

In a method of the first aspect of the present invention the fiber material may comprise a plurality of chopped fibers, which is advantageous in that it may result in a more cost-effective method as compared to methods wherein non-chopped fibers are used.

In preferred embodiments of a method of the first aspect of the present invention the fiber material may be a glass fiber material, which is advantageous in that a glass fiber material may have a refractive index close to, e.g. substantially equal to the refractive index of the encapsulant material, this refractive index furthermore having a value resulting in a good transparency for light in a wavelength range that is absorbed by the at least one photovoltaic cell. This is particularly advantageous in embodiments wherein the contact foil is used at a light-receiving surface of the at least one photovoltaic cell. In embodiments wherein the contact foil is used at a non-light-receiving surface of the at least one photovoltaic cell, other types of fiber material may also be used, such as for example a basalt fiber material or a natural fiber material such as flax fiber or hemp fiber.

In the present invention, establishing an electrical connection between at least one metal contact at the surface of the at least one photovoltaic cell and at least one electrically conductive wire of the contact sheet comprises soldering. The plurality of electrically conductive wires is covered by or coated with a solderable material, for example a solder or solder alloy. This is advantageous in that the at least one photovoltaic cell can be electrically contacted during the heating step, simultaneously with cell encapsulation, without the need for dispensing a conductive paste or a solder paste, thereby avoiding costs, process steps, handling operations and/or alignment steps related to paste dispensing.

It is an advantage of embodiments of the method of the first aspect of the present invention that solder flow during the heating step is substantially reduced as compared to known methods. The reduced solder flow advantageously leads to a substantially improved solder accumulation between the electrically conductive wires and the metal contacts and an improved, more uniform, solder distribution with less interruptions, resulting in better electrical contacts with a lower contact resistance as compared to known approaches wherein no fiber material is used. This may further lead to an improved electrical reliability of the at least one photovoltaic cell.

It is an advantage of embodiments of the method of the first aspect of the present invention that, when applying a pressure during the heating process, the pressure distribution over the at least one photovoltaic cell is improved, i.e. pressure differences are reduced, as compared to known approaches without using a fiber material in between the at least one photovoltaic cell and the carrier. This advantageously leads to a reduced displacement of encapsulant material from regions with higher pressure to regions with lower pressure and thus to an improved distribution of the electrically insulating encapsulant material over the surface of the at least one photovoltaic cell. This further advantageously results in a reduced solder flow and thus an improved solder distribution.

In methods not part of the present invention, establishing an electrical connection between at least one metal contact at the surface of the at least one photovoltaic cell and at least one electrically conductive wire of the contact sheet may comprise gluing. In such methods the plurality of electrically conductive wires is preferably covered by or coated with an electrically conductive adhesive. This is advantageous in that the at least one photovoltaic cell can be electrically contacted during the heating step, simultaneously with cell encapsulation, thereby avoiding costs, process steps, handling operations and/or alignment steps related to dispensing of electrically conductive material.

In embodiments of the method of the first aspect of the present invention, the carrier may be a rigid carrier, such as for example a glass plate or a quartz plate, or it may be a flexible carrier, such as for example a polyvinyl fluoride foil, a polyethylene terephthalate foil or a polycarbonate foil. The carrier may be optically transparent, translucent or non-translucent.

In embodiments of a method for electrically contacting at least one photovoltaic cell, bringing the contact sheet into physical contact with the surface of the at least one photovoltaic cell comprises bringing a first part of the into physical contact with the surface of a first photovoltaic cell and bringing a second part of the contact sheet into physical contact with the surface of a second photovoltaic cell. In such embodiments, when performing the heating process, at least one first metal contact at the surface of the first photovoltaic cell and at least one second metal contact at the surface of the second photovoltaic cell are electrically connected to a same electrically conductive wire of the contact sheet. Thereby the first photovoltaic cell is electrically connected with the second photovoltaic cell by means of said same electrically conductive wire. Performing the heating process leads to the formation of a laminate comprising a stack comprising the first photovoltaic cell and the second photovoltaic cell side by side, e.g. next to each other, the contact sheet and the carrier. The contact sheet comprises a fiber material that is incorporated between the first photovoltaic cell and the carrier and between the second photovoltaic cell and the carrier. The electrically insulating encapsulant material is a thermoplastic material. In methods not part of the invention the electrically insulating encapsulant material may for example be a (partially) curing material, a thermosetting material or a combination of different materials.

In such embodiments when electrically contacting the at least one photovoltaic cell (the first photovoltaic cell and the second photovoltaic cell), the photovoltaic cells are simultaneously electrically connected.

The physical contact between the first part of the contact sheet and the first photovoltaic cell at one hand and the physical contact between the second part of the contact sheet and the second photovoltaic cell at the other hand may be established at a different, opposite side of the contact sheet. In such embodiments, covering the contact sheet with the carrier comprises covering the contact sheet with a carrier at both opposite sides. In such embodiments two carriers are provided, one carrier at each side of the assembly comprising the contact sheet with the first photovoltaic cell and the second photovoltaic cell in physical contact therewith. A first carrier is provided at the front side of the assembly and a second carrier is provided at the back side of the assembly.

Alternatively, the physical contact between the first part of the contact sheet and the first photovoltaic cell at one hand and the physical contact between the second art of the contact sheet and the second photovoltaic cell may be established at a same side of the contact sheet.

According to an embodiment, a method for fabricating a photovoltaic module is provided.

In general, features of this embodiment provide similar advantages as discussed above in relation to the previous aspect of the invention.

A method for fabricating a photovoltaic module comprising a plurality of photovoltaic cells is provided, wherein the method comprises electrically contacting at least one photovoltaic cell of the plurality of photovoltaic cells using the method according to the first aspect of present invention. This method may further comprise electrically contacting the photovoltaic cells simultaneously with electrically contacting the photovoltaic cells.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the figures

FIG 1 shows a flowchart of an example of a method for electrically contacting a photovoltaic cell in accordance with an embodiment of the first aspect of the present invention.
FIG 2 schematically illustrates an example of a method for electrically contacting a photovoltaic cell in accordance with an embodiment of the first aspect of the present invention.
FIG 3 shows a flowchart of an example of a method for electrically contacting and electrically connecting a first photovoltaic cell with a second photovoltaic cell in accordance with an embodiment of the first aspect of the present invention.
FIG 4 schematically illustrates an example of a method for electrically contacting and electrically connecting a first photovoltaic cell with a second photovoltaic cell in accordance with an embodiment of the first aspect of the present invention, wherein the first photovoltaic cell and the second photovoltaic cell are busbar-free cells with contacts at both cell surfaces.
FIG 5 schematically illustrates an example of a method for electrically contacting and electrically connecting a first photovoltaic cell with a second photovoltaic cell in accordance with an embodiment of the first aspect of the present invention, wherein the first photovoltaic cell and the second photovoltaic cell are back-contact cells.
FIG 6 schematically illustrates an example of a method for electrically contacting a bifacial photovoltaic cell in accordance with an embodiment of the present invention.

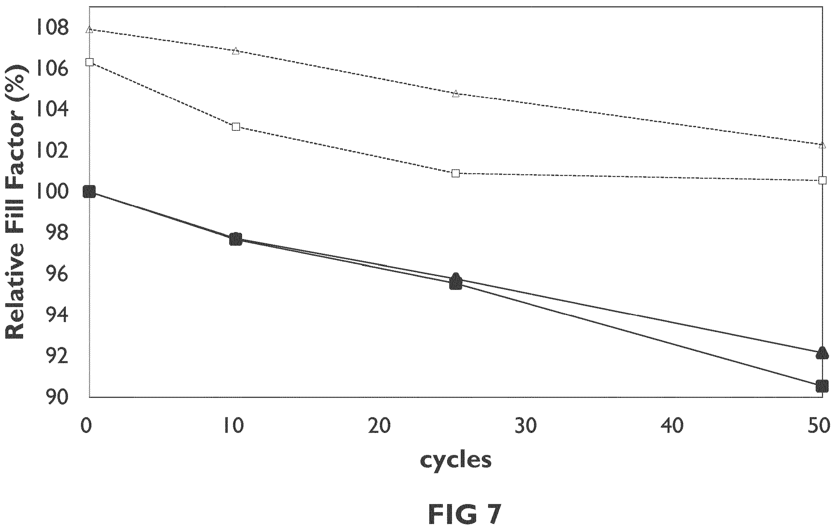

FIG 7 shows the relative FF of electrically contacted and encapsulated bifacial photovoltaic cells measured under thermal cycling, as a function of the number of thermal cycles. Filled symbols represent results for structures fabricated according to a prior art method. Open symbols represent results for structures fabricated using a method in accordance with the first aspect of the present invention, for an example wherein a plain-woven glass fiber fabric was used for forming the contact sheet. Squares represent structures with a thermoplastic encapsulant material; triangles represent structures with a partially curing encapsulant material.
FIG 8 shows the relative FF of electrically contacted and encapsulated bifacial photovoltaic cells measured under thermal cycling, as a function of the number of thermal cycles. Square symbols represent results obtained using a thermoplastic encapsulation material (filled squares with full line: reference sample without glass fiber). Triangles represent results for a partially curing encapsulant material and circles represent results for a fully curing encapsulant material, for examples wherein a non-woven chopped glass fiber sheet was used for forming the contact sheet.

In the different figures, the same reference signs refer to the same or analogous elements.

### Detailed description

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this invention, in one or more embodiments.

Similarly it should be appreciated that in the description of exemplary embodiments of the invention, various features of the invention are sometimes grouped together in a single embodiment, figure, or description thereof for the purpose of streamlining the invention and aiding in the understanding of one or more of the various inventive aspects. This method of invention, however, is not to be interpreted as reflecting an intention that the claimed invention requires more features than are expressly recited in each claim. Rather, as the following claims reflect, inventive aspects lie in less than all features of a single foregoing disclosed embodiment.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

In the context of the present invention, the front surface or front side of a photovoltaic cell or of a photovoltaic module refers to the surface or side adapted for being oriented towards a light source and thus for receiving illumination. However, in case of bifacial photovoltaic cells or modules, both surfaces are adapted to receive impinging light. In such case, the front surface or front side is the surface or side adapted for receiving the largest fraction of the light or illumination. The back surface, rear surface, back side or rear side of a photovoltaic cell or a photovoltaic module is the surface or side opposite to the front surface or side.

In the context of the present invention, a busbar refers to an electrically conductive strip for collecting an electrical current, e.g. a current generated under illumination, from a plurality of metal contacts or metal electrodes provided on a surface of a photovoltaic cell. A busbar is typically provided for direct electrical connection with an external electrical lead. A busbar typically collects the current from finer or narrower metal contacts, also called metal fingers, on the cell. These finer or narrower metal contacts collect current from the cell and deliver the current to the busbars; they are typically not provided for direct electrical connection to an external electrical lead.

In the context of the present invention, a busbar-free photovoltaic cell is a photovoltaic cell not having busbars. A busbar-free photovoltaic cell may typically comprise a plurality of metal contacts at a surface of the cell, but after cell fabrication it does not comprise an electrically conductive element for collecting current from the plurality of metal contacts. After finishing he cell fabrication, for example during module fabrication, electrically conductive elements such as for example electrically conductive wires may be connected to, e.g. soldered to, the plurality of metal contacts. These electrically conductive elements are provided for collecting an electrical current from the plurality of metal electrodes and they may replace the conventional busbars.

In the context of the present invention, the term 'wire' refers to an elongate element that has a wire-like form or shape. For example, it may refer to a thread, a wire, a filament, a strand, a ribbon, a strip, a tape, a rod, a tubular structure or a similar elongate element. A wire may have a homogeneous structure, e.g. obtained by extrusion, or a composite structure, e.g. by combining component filaments into a thread or strand. A wire may be composed of a single material or may comprise a combination of materials.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

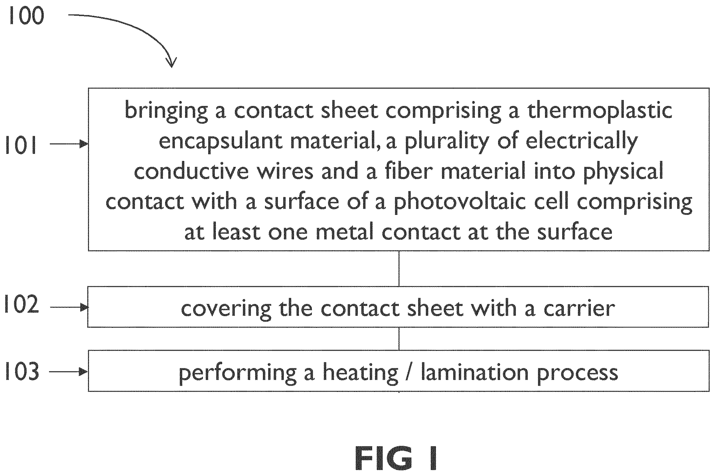

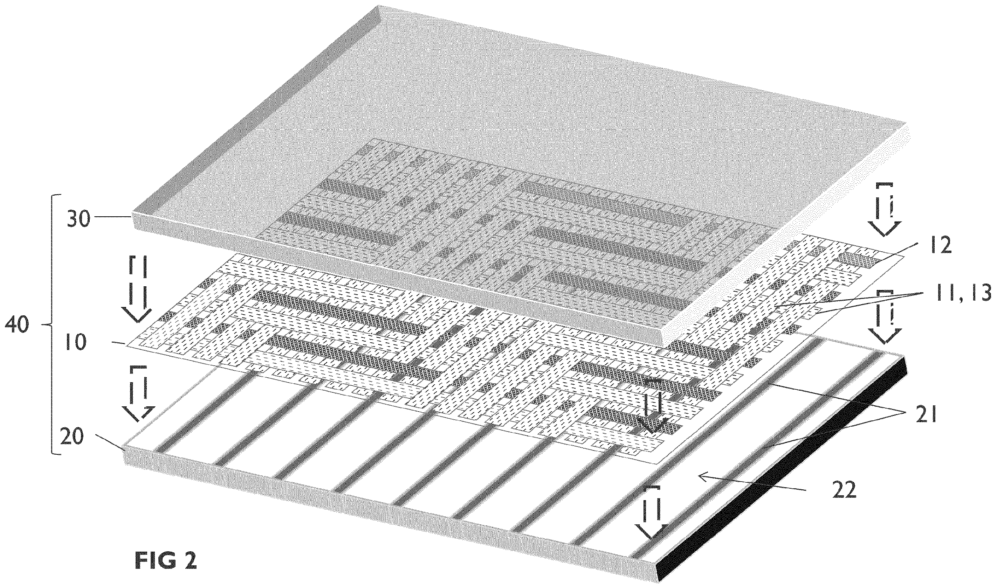

In a first aspect, the present invention provides a method for electrically contacting a photovoltaic cell. A flowchart of an example of a method for electrically contacting a photovoltaic cell in accordance with an embodiment of the first aspect of the present invention is shown in the flowchart of FIG 1. The example is further schematically illustrated in FIG 2.

In a method 100 as shown in the example of FIG 1 and illustrated in FIG 2, step 101 comprises bringing a contact sheet 10 into physical contact with a surface 22 of a photovoltaic cell 20, the photovoltaic cell 20 comprising at least one metal contact 21, in the example shown a plurality of metal contacts 21, at that surface 22. Thereby a layer stack comprising the photovoltaic cell 20 and the contact sheet 10 is formed (FIG 2). The contact sheet 10 comprises an electrically insulating encapsulant material 11, a plurality of electrically conductive wires 12 and a fiber material 13 (FIG 2). In the example illustrated in FIG 2, the fiber material 13 is shown embedded in the electrically insulating encapsulant material 11 (the fiber material 13 being illustrated in FIG 2 by the stripes in the encapsulant material 11). When bringing the contact sheet 10 into physical contact with the surface of the photovoltaic cell 20, exposed parts of the plurality of electrically conductive wires 12 are aligned with metal contacts 21 of the photovoltaic cell 20 to which an electrical contact is to be established.

In the example illustrated in FIG 2 the electrically insulating encapsulant material 11 comprises a plurality of electrically insulating wires (in FIG 2 shown in the form of ribbons), interwoven with the plurality of electrically conductive wires 12, thereby forming a woven fabric. In the woven fabric illustrated in the example of FIG 2, the plurality of electrically insulating wires 11 is provided in both the warp and weft directions of the fabric. However, the present invention is not limited thereto. In other embodiments the plurality of electrically insulating wires may be provided in a single one of the warp and the weft directions. FIG 2 illustrates an example wherein the plurality of electrically conductive wires 12 is provided in a single one of the warp and weft directions of the woven fabric. However, the present invention is not limited thereto and in embodiments the plurality of electrically conductive wires may be provided in both the warp and weft directions.

In an alternative approach (not illustrated), the electrically insulating encapsulant material may comprise a plane encapsulant sheet, e.g. an encapsulant foil. In such embodiments the plurality of electrically conductive wires may be attached to or integrated with the encapsulant sheet, such as for example by printing, stitching, sewing or heating.

The electrically insulating encapsulant material 11 is composed of a thermoplastic polymer that allows ensuring sufficient structural and electrical separation between the electrically conductive wires before, during and after lamination. It preferably has a good UV resistance and a good resistance against humidity. For example, it may comprise, or may be composed of, a polyolefin material, a thermoplastic polyurethane (TPU) or a polyvinyl butyral (PVB).

In embodiments of the present invention at least part of the plurality of electrically conductive wires 12 is at least partially exposed at a surface of the contact sheet 10 (FIG 2), preferably at both surfaces of the contact sheet. The electrically conductive wires may comprise a metal, e.g. a metal having a high electrical conductivity, such as copper, aluminum, gold or silver. For example, the electrically conductive wires may comprise copper ribbons.

The electrically conductive wires are covered by or coated with a solderable material, e.g. a solder or solder alloy. For example, the electrically conductive wires may comprise solder-coated copper ribbons. They may be coated with a low temperature solder material, such as for example a solder alloy for soldering at a temperature in the range between 20°C and 300°C, for example between 50° C and 150°C, for example between 60°C and 100°C. For example, a solder alloy comprising Sn, Bi, In, Cd, Zn, Ag, Pb and/or Co may be used.

Alternatively, in methods not part of this invention, the electrically conductive wires may be covered with or coated with an electrically conductive adhesive material, such as for example an adhesive material based on a cyanoacrylate, an epoxy, a silicone or an acryl, with an electrically conductive filler material such as for example a Ag, Cu or Ni based filler material.

In embodiments the fiber material 13 may be embedded in the electrically insulating encapsulant material 11, as schematically illustrated in the example of FIG 2. This may for example be done by mixing the fiber material, which may be provided in the form of chopped fibers, with the raw materials (for example the encapsulant precursors) used for making the encapsulant material, before encapsulant sheet or ribbon fabrication, i.e. before actually forming the encapsulant material. The fiber material may comprise a plurality of chopped fibers. The fiber material may be randomly distributed in the encapsulant material.

In embodiments the fiber material may be provided in the form of a fiber sheet such as for example a chopped fiber mat (e.g. a chopped strand mat), a continuous fiber mat (e.g. a continuous filament mat or a continuous strand mat), a fiber mesh or a fiber fabric (e.g. a woven fabric). The fiber sheet may be laminated with an encapsulant sheet comprising the electrically insulating encapsulant material. This may be done by forming a stack comprising the fiber sheet and the encapsulant sheet and subjecting the stack to a heating step, thereby liquefying the electrically insulating encapsulant material of the encapsulant sheet and impregnating the glass fiber sheet with the encapsulant material.

In a next step 102 of the exemplary method 100 (FIG 1, schematically illustrated in FIG 2), the contact sheet 10 is covered with a carrier 30, at a side of the contact sheet 10 opposite to the side where it is in contact with the surface 22 of the photovoltaic cell 20. This results in a [photovoltaic cell 20 / contact sheet 10 / carrier 30] layer stack 40 (FIG 2). The carrier 30 may be a rigid carrier, such as for example a glass plate or a quartz plate, or it may be a flexible carrier, such as for example a polyvinyl fluoride (PVF) foil, a polyethylene terephthalate (PET) foil or a polycarbonate (PC) foil.

This stack 40 is then subjected to a heating process (FIG 1, step 103), thereby forming a [photovoltaic cell 20 / contact sheet 10 / carrier 30] laminate. This heating process results in the formation of an electrical connection between at least one metal contact 21 of the photovoltaic cell 20 and at least one electrically conductive wire 12 of the contact sheet 10, at a location where the at least one electrically conductive wire is exposed and in contact with / aligned to the at least one metal contact. Since the plurality of electrically conductive wires 12 comprises a solder coating, the electrical connections are established by soldering. In methods not part of the invention the plurality of electrically conductive wires 12 may be coated with an electrically conductive adhesive material, and the electrical connections may be established by gluing. The heating process further results in liquefication of the encapsulant material 11. Upon cooling of the stack, the photovoltaic cell 20 is encapsulated, the carrier 30 is attached to the contact sheet 10 by adhesion of the encapsulant material 11 to the carrier 30 and the contact sheet 10 is attached to the surface of the photovoltaic cell 20 by adhesion of the encapsulant material 11 to the surface 22 of the photovoltaic cell. This results in the formation of a laminate comprising a stack of the photovoltaic cell 20, the contact sheet 10 and the cover 30.

After having performed the heating process (followed by a cooling process), an encapsulated and electrically contacted photovoltaic cell is obtained, at least one metal contact of the photovoltaic cell being electrically connected to at least one electrically conductive wire of the contact sheet. Metal contacts of a same polarity may be electrically connected to a same electrically conductive wire, i.e. metal contacts of a same polarity may be electrically interconnected by an electrically conductive wire of the contact sheet. In operation, an electrical current generated by the photovoltaic cell is collected at the metal contacts of the cell and this current can be further collected by the electrically conductive wires that are electrically connected to these metal contacts. The electrically conductive wires can be further connected to an external lead, e.g. by soldering. This may for example also be done during the heating / lamination step. The electrically conductive wires may thus replace the busbars of photovoltaic cells.

The heating / lamination process may be done in a standard laminator as used in known methods for encapsulating photovoltaic modules. During heating, a pressure may be applied, for example a pressure in the range between 0.6 bar and 1 bar, embodiments of the present invention not being limited thereto.

The heating step may be a heating process comprising a first heating step at a first temperature and a second heating step at a second temperature. The first temperature, e.g. the temperature to which the stack is heated during the first heating step, may be selected based on the melting temperature of the solder material, e.g. the solder coating of the plurality of electrically conductive wires, and taking into account the melting temperature of the electrically insulating encapsulant material. The first temperature is preferably higher than the melting temperature of a solder alloy coating of the electrically conductive wires and preferably lower than the melting temperature of the electrically insulating encapsulant material. The first temperature may, for example, be in the range between 45°C and 400°C, preferably in the range between 120°C and 240°C. During this first heating step, the solder coating on the electrically conductive wires may melt such that solder joints are created with the metal contacts of the cell. In other words, the electrically conductive wires may be soldered to the metal contacts at the locations where the electrically conductive wires are in contact with the metal contacts. This may thus result in electrical connections being established between metal contacts of the photovoltaic cell and electrically conductive wires of the contact sheet.

After soldering (resulting from the first step of the heating process), the temperature may be raised to a second temperature to perform a second step of the heating process. The second temperature is selected based on the melting temperature of the electrically insulating encapsulant material. Preferably the encapsulant material has a melting temperature that is higher, such as for example 10°C to 50°C higher, than a soldering temperature of the electrically conductive wires, e.g. than a melting temperature of a solder alloy coating of the electrically conductive wires. As a result of this second heating step, the encapsulant material may liquefy, e.g. may melt, such as to transform the encapsulant material into a smooth cell encapsulation layer.

It is an advantage of using such a two-step heating process as described hereinabove that the first heating step, corresponding to the soldering, can be performed at a first temperature that is lower than the melting temperature of the electrically insulating encapsulant material. Therefore, during soldering, the encapsulant material is not yet liquefied and thus the risk of penetration of encapsulant material between the metal contacts and the electrically conductive wires, which could lead to connections with a high electrical resistance, is avoided.

**In** embodiments of the present invention wherein the contact sheet is provided at a light receiving surface of the photovoltaic cell (the front side of the photovoltaic cell or, in case of a bifacial photovoltaic cell, both the front side and the rear side the cell), the electrically insulating encapsulant material and the carrier are preferably substantially optically transparent, at least in a wavelength region that is absorbed by the photovoltaic cell. For example, the optical transparency may be higher than 95%, preferably higher than 98%, for light in the wavelength range between 350 nm and 1000 nm, preferably for light in the wavelength range between 240 nm and 1200 nm. In such embodiments the fiber material is preferably selected to have a refractive index close to, preferably substantially equal to, the refractive index of the electrically insulating encapsulant material. For example, the difference in refractive index between the fiber material and the electrically insulating material may be lower than 0.15, preferably lower than 0.10. The fiber material may for example be a glass fiber material.

**In** embodiments wherein the contact sheet is provided at a non-light-receiving surface of the photovoltaic cell the carrier may be either transparent or non-transparent. In such embodiments the fiber material may for example comprise glass fiber, basalt fiber or a natural fiber such as flax fiber or hemp fiber.

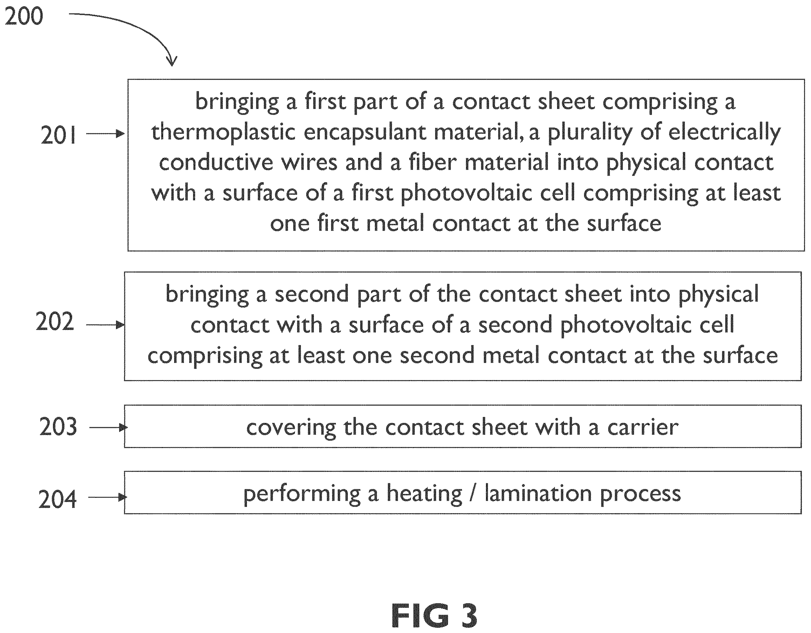

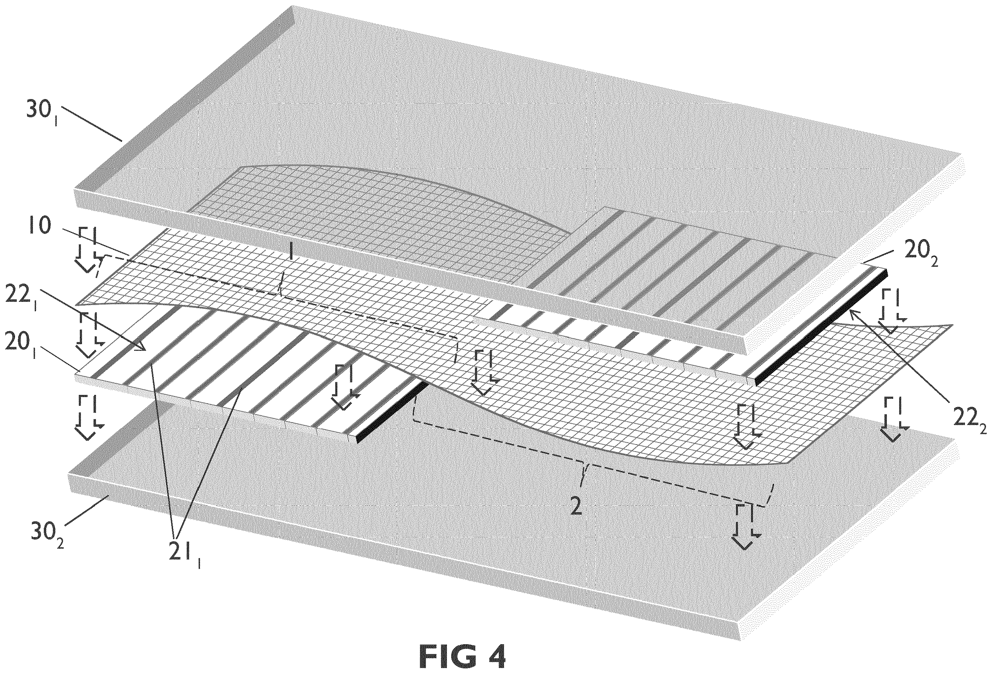

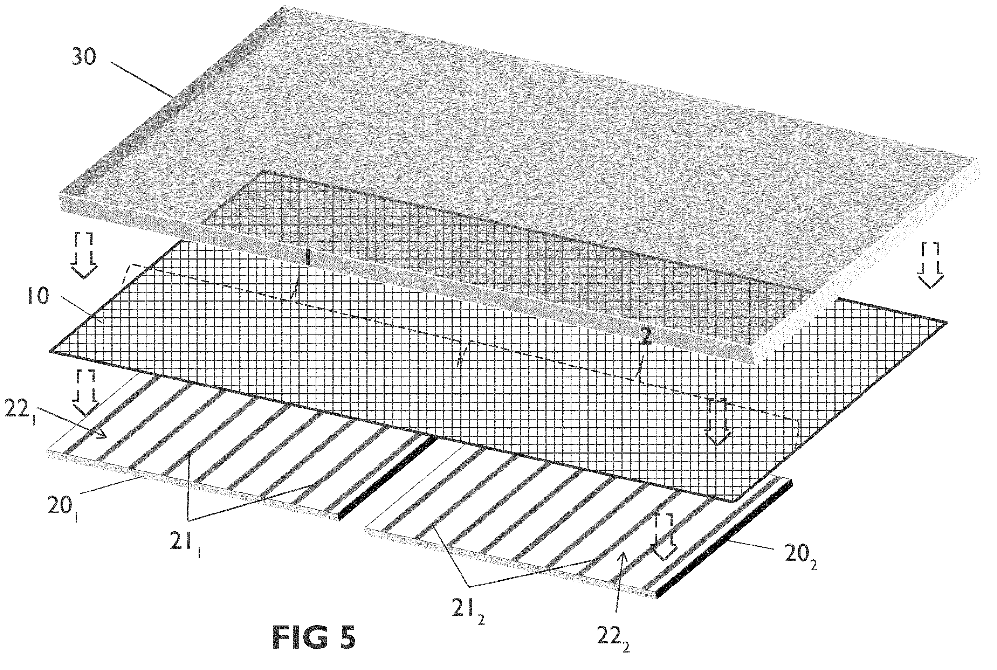

In further embodiments of a method for electrically contacting at least one photovoltaic cell, the present invention provides a method for simultaneously electrically contacting and electrically connecting photovoltaic cells, e.g. busbar-free photovoltaic cells, for example as part of a method for fabricating a photovoltaic module. A flowchart of an example of a method for electrically contacting and (simultaneously) electrically connecting a first photovoltaic cell comprising at least one first metal contact, e.g. a plurality of first metal contacts, at a surface of the cell and a second photovoltaic cell comprising at least one second metal contact, e.g. a plurality of second metal contacts, at a surface of the cell, in accordance with an embodiment is shown in the flowchart shown in FIG 3. Examples are further schematically illustrated in FIG 4 and FIG 5.

In an exemplary method 200 as shown in FIG 3 and further illustrated in FIG 4 and FIG 5, step 201 comprises bringing a first part 1 of a contact sheet 10 into physical contact with a surface 22₁ of a first photovoltaic cell 20₁, the first photovoltaic cell 20₁ comprising at least one first metal contact 21₁, at that surface 22₁. Step 202 of the method 200 comprises bringing a second part 2 of the contact sheet 10 into physical contact with a surface of a second photovoltaic cell 20₂, the second photovoltaic cell 20₂ comprising at least one second metal contact 21₂ at that surface 22₂. The contact sheet 10 comprises an electrically insulating encapsulant material, a plurality of electrically conductive wires and a fiber material, as described above in relation with the first aspect of the present invention.

The first part 1 of the contact sheet 10 may have a size and shape that fits the size and shape of the first photovoltaic cell 20₁ and the second part 2 of the contact sheet 10 may have a size and shape that fits the size and shape of the second photovoltaic cell 20₂, the present invention not being limited thereto.

In embodiments the physical contact between the first part 1 of the contact sheet 10 and the surface 22₁ of the first photovoltaic cell 20₁ at one hand and the physical contact between the second part 2 of the contact sheet 10 and the surface 22₂ of the second photovoltaic cell 20₂ at the other hand may be established at a different, opposite side of the contact sheet 10. In other words, the first part 1 of the contact sheet may be brought into contact with the first photovoltaic cell 20₁ at a first side of the contact sheet 10 and the second part 2 of the contact sheet may be brought into contact with the second photovoltaic cell 20₂ at a second side of the contact sheet, in which the first side and the second side are opposite sides of the contact sheet. An example of such embodiment is schematically illustrated of FIG 4. This approach may for example be used in embodiments wherein a front side contact of the first photovoltaic cell 20₁ is to be electrically connected to the back-side contact of the second photovoltaic cell 20₂, to thereby connect the first photovoltaic cell 20₁ and the second photovoltaic cell 20₂ in series. In the illustration shown in FIG 4, the surface 22₂ of the second photovoltaic cell 21₂ comprising the at least one second metal contact 21₂ to which a connection is to be established (corresponding to the surface 22₂ to which the second part 2 of the contact sheet 10 is brought into physical contact) is not visible. As indicated by the arrow, the surface 22₂ is opposite to the surface that is visible in FIG 4. The at least one second metal contact 21₂ (not shown in FIG 4) at that surface 22₂ may for example consist of a single metal contact 21₂, e.g. covering a substantial part of the surface 22₂ (e.g. substantially the entire surface 22₂), or it may comprise a plurality of second metal contacts 21₂.

In alternative embodiments the physical contact between the first part 1 of the contact sheet 10 and the surface 22₁ of the first photovoltaic cell 20₁ at one hand and the physical contact between the second part 2 of the contact sheet 10 and the surface 22₂ of the second photovoltaic cell 20₂ at the other hand may be established at a same side of the contact sheet 10. In other words, the first photovoltaic cell 20₁ and the second photovoltaic cell 20₂ may be present at a same side of the contact sheet 10. An example of such embodiment is schematically illustrated in FIG 5. This approach may for example be used in embodiments wherein a front side contact of the first photovoltaic cell 20₁ is to be electrically connected to the front side contact of the second photovoltaic cell 20₂, and/ or wherein the back-side contact of the first photovoltaic cell 20₁ is to be electrically connected to the back-side contact of the second photovoltaic cell 20₂ to thereby connect the first photovoltaic cell 20₁ and the second photovoltaic cell 20₂ in parallel. This approach may for example also be used in embodiments wherein the first photovoltaic cell 20₁ and the second photovoltaic cell 20₂ are back-contact cells, wherein the first photovoltaic cell 20₁ and the second photovoltaic cell are to be connected in series.

In a next step of the exemplary method 200 (FIG 3, schematically illustrated in FIG 4 and FIG 5), the contact sheet 10 is covered with a carrier 30, 30₁, 30₂, at a side of the contact sheet 10 opposite to the side where it is in contact with the surface 22₁ of the first photovoltaic cell 20₁ and at a side of the contact sheet 10 opposite to the side where it is in contact with the surface 22₂ of the second photovoltaic cell 20₂. The carrier 30, 30₁, 30₂ may be a rigid carrier, such as for example a glass plate or a quartz plate, or it may be a flexible carrier, such as for example a polyvinyl fluoride (PVF) foil, a polyethylene terephthalate (PET) foil or a polycarbonate (PC) foil.

In embodiments wherein the physical contact between the first part 1 of the contact sheet 10 and the surface 22₁ of the first photovoltaic cell 20₁ at one hand and the physical contact between the second part 2 of the contact sheet 10 and the surface 22₂ of the second photovoltaic cell 20₂ at the other hand is established at the same side of the contact sheet 10 (as for example illustrated in FIG 5), step 203 of covering the contact sheet 10 with a carrier may comprise providing a single carrier 30, at one side of the contact sheet. However, the present invention is not limited thereto, and an additional carrier may be provided at an opposite side of the assembly comprising the contact sheet 10 with the first photovoltaic cell 20₁ and the second photovoltaic cell 20₂ in physical contact therewith.

In embodiments wherein the physical contact between the first part 1 of the contact sheet 10 and the surface 22₁ of the first photovoltaic cell 20₁ at one hand and the physical contact between the second part 2 of the contact sheet 10 and the surface 22₂ of the second photovoltaic cell 20₂ at the other hand is established at different, opposite sides of the contact sheet (as for example illustrated in FIG 4), step (203) of covering the contact sheet 10 with a carrier comprises providing two carriers 30₁, 30₂, one carrier at each side of the assembly comprising the contact sheet 10 with the first photovoltaic cell 20₁ and the second photovoltaic cell 20₂ in physical contact therewith. As illustrated in FIG 4, a first carrier 30₁ is provided at a first side of the assembly (e.g. corresponding to the front side of the first and second photovoltaic cells 20₁, 20₂) and a second carrier 30₂ is provided at a second side (e.g. corresponding to the back side of the first and second photovoltaic cells 20₁, 20₂) of the assembly, opposite to the first side.

This assembly is then subjected to a heating process (FIG 3, step 204), thereby forming a laminate. This heating process results in the formation of an electrical connection between at least one first metal contact 21₁ of the first photovoltaic cell 20₁ and at least one electrically conductive wire 12 of the contact sheet 10, at a location where the at least one electrically conductive wire 12 is exposed and in contact with / aligned to the at least one first metal contact 21₁. This heating process further results in the formation of an electrical connection between at least one second metal contact 21₂ of the second photovoltaic cell 20₂ and the at least one electrically conductive wire 12 of the contact sheet 10, at a location where the at least one electrically conductive wire 12 is exposed and in contact with / aligned to the at least one second metal contact 21₂. The plurality of electrically conductive wires 12 comprises a solder coating, and the electrical connections are established by soldering. In methods not part of the invention wherein the plurality of electrically conductive wires 12 is coated with an electrically conductive adhesive material, the electrical connections are established by gluing. The heating process further results in liquefication of the electrically insulating encapsulant material 11. Upon cooling of the assembly, the first photovoltaic cell 20₁ and the second photovoltaic cell 20₂ are encapsulated, the carrier 30, 30₁, 30₂ is attached to the contact sheet 10 by adhesion of the encapsulant material 11 to the carrier 30, 30₁, 30₂, and the contact sheet 10 is attached to the surface 22₁ of the first photovoltaic cell 20₁ by adhesion of the electrically insulating encapsulant material to that surface 22₁, the contact sheet 10 further being attached to the surface 22₂ of the second photovoltaic cell 20₂ by adhesion of the encapsulant material 11 to that surface 22₂. This results in the formation of a laminate comprising a stack comprising the first photovoltaic cell 20₁ and the second photovoltaic cell 20₂ (side by side, for example next to each other), the contact sheet 10 and the carrier 30, 30₁, 30₂.

After having performed the heating process (followed by a cooling process), a structure comprising encapsulated, electrically contacted and electrically connected photovoltaic cells is obtained, at least one metal contact of a first photovoltaic cell and at least one metal contact of a second photovoltaic cell being electrically connected to a same electrically conductive wire of the contact sheet.

The heating / lamination process may be done as for example described above related to the method of the first aspect of the present invention.

Further, a method for fabricating a photovoltaic module is provided. The *method for fabricating a photovoltaic module comprises electrically contacting and simultaneously electrically connecting a plurality of photovoltaic cells using a method in accordance with an embodiment of the first aspect of the present invention.

Examples are provided hereinbelow, which illustrate experiments in which a method according to embodiments of the present invention was used for electrically contacting and simultaneously encapsulating photovoltaic cells. These examples are provided for illustrating features and advantages of embodiments of the present invention, and to aid the skilled person in reducing the invention to practice. However, these examples should not be construed as limiting the invention in any way.

Experiments were performed wherein contact sheets comprising an electrically insulating encapsulant material, glass fiber material and a plurality of electrically conductive wires were made by first forming a stack of a plain-woven glass fiber fabric with an encapsulant sheet, and then stitching twenty SnBi-coated copper wires (200 micrometer diameter) through the stack. In these experiments, two different types of polyolefin encapsulant material were used: in a first experiment a thermoplastic polyolefin material was used (sheet thickness 408 micrometer), further referred to as 'type A' material, whereas in a second experiment a partially curing polyolefin material (sheet thickness 500 micrometer) was used, further referred to as 'type B' material.

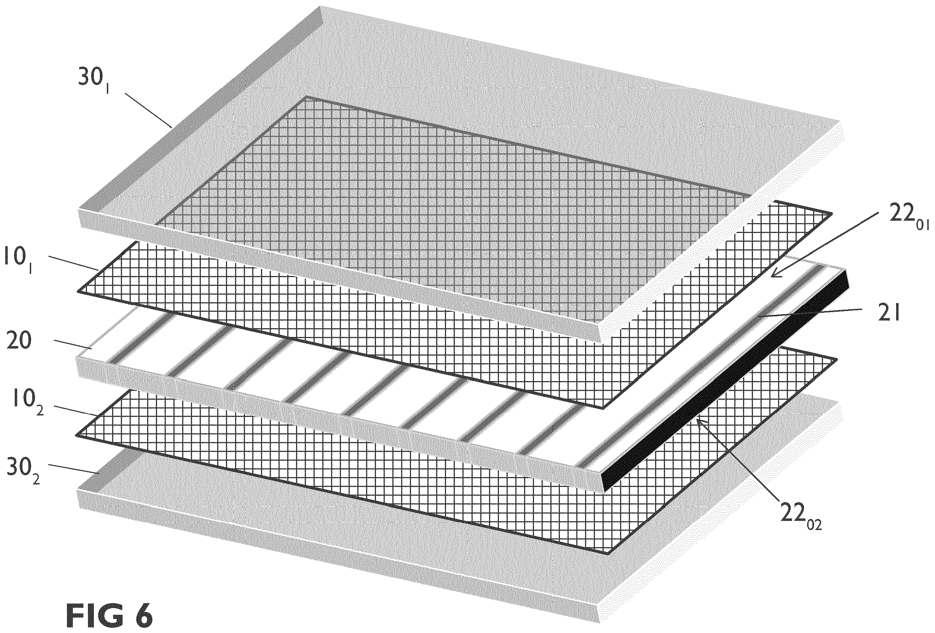

As schematically illustrated in FIG 6, one contact sheet 10₁ was brought into physical contact with the front surface 22₀₁ of a bifacial photovoltaic cell 20 comprising a plurality of metal contacts 21 at the front surface 22₀₁, and another contact sheet 10₂ was brought into physical contact with the rear surface 22₀₂ of the bifacial photovoltaic cell 20. The bifacial photovoltaic cell 20 used was a busbar-free cell, comprising a plurality of metal contacts 21 consisting of printed metal fingers 21 at the front surface 22₀₁ of the cell and comprising also at its rear surface 22₀₂ a plurality of metal contacts (not shown in FIG 6) consisting of printed metal fingers. Electrically conductive wires of the contact sheets 10₁, 10₂ were aligned to metal contacts 21 of the bifacial cell 20. Next, as a carrier, a glass plate 30₁, 30₂ was provided over the contact sheets 10₁, 10₂, at both sides of the bifacial photovoltaic cell 20. The resulting stack (first glass plate 30₁ / first contact sheet 10₁ / bifacial photovoltaic cell 20 / second contact sheet 10₂ / second glass plate 30₂) was laminated by heating to 165°C, using an 11 minutes compression step at 700 mbar, thereby forming an electrically contacted and encapsulated bifacial cell.

The electrically contacted and encapsulated bifacial cells were subjected to thermal cycling tests, according to IEC 61215 and IEC 61646 standards, comprising thermal cycling between -40°C and +80°C. The results of the thermal cycling tests are represented in FIG 7, showing the measured relative fill factor (FF) of the encapsulated cells as a function of the number of thermal cycles performed. Filled symbols represent results for structures without glass fiber, and open symbols represent results for structures with glass fiber in accordance with the present invention. Squares represent structures with 'type A' encapsulant material; triangles represent structures with 'type B' encapsulant material. It was observed that the initial electrical performance of the encapsulated cells made using a method in accordance with the present invention was improved as compared to similar structures made with the same types of polyolefin based encapsulant material but without glass fiber. As illustrated in FIG 7, for the encapsulated cells with 'type A' encapsulant material an improvement of 6% of the initial fill factor was observed for samples comprising glass fiber material (open squares) as compared to samples comprising no glass fiber material (filled squares). For encapsulated cells with 'type B' encapsulant material an improvement of 8% of the initial fill factor was found for samples comprising glass fiber material (open triangles) as compared to samples comprising no glass fiber material (filled triangles). Further, a substantial reduction of the fill factor degradation under thermal cycling was observed for structures comprising glass fiber as compared to similar structures without glass fiber. Without being bound by theory, it is presumed that the reduced thermal degradation may be related to a reduced thermal expansion coefficient of the encapsulant, a reduced shifting and/or better fixation of the electrically conductive wires of the contact sheets during lamination, resulting in a reduced interruption of solder contacts during the heating and cooling steps performed as part of the lamination process.

Further experiments were performed with contact sheets containing chopped glass fibers instead of a plain-woven glass fiber fabric. In these experiments, pre-manufactured non-woven glass fiber sheets (fiber foils) comprising chopped glass fibers were used for making contact sheets. The non-woven glass fiber sheets had the following properties: weight about 35 g/m², glass fiber length about 2 cm, glass fiber diameter in the range between 9 and 12 micrometer, thickness about 200 micrometer. It is an advantage of using chopped glass fibers that it may result in a lower cost and to a more homogenous distribution of glass fiber material in random orientations within the contact sheet.

Different approaches were followed for forming the contact sheets. In a first approach, contact sheets were made by first forming a stack of a non-woven glass fiber sheet comprising chopped glass fibers with an encapsulant sheet, and then stitching twenty SnBi-coated copper wires (200 micrometer diameter) through to the stack of the encapsulant sheet and the glass fiber sheet. This approach is similar to the approach described above in relation with the experiments using a plain-woven glass fiber fabric. Different types of encapsulant materials were used for these encapsulant sheets: 'type A' polyolefin material (a thermoplastic polyolefin-based material, as described above); 'type B' polyolefin material (a partially curing polyolefin-based material as described above) and EVA (ethylene-vinyl acetate).

In a second approach, contact sheets were made by pre-laminating an encapsulant sheet (thickness 408 micrometer) comprising 'type A' material with a glass fiber sheet comprising chopped glass fibers. The 'type A' encapsulant material is non-curing (not cross linking) during heating, being thermoplastic polyolefin based. The pre-lamination step was performed at a temperature of 165°C, 1000 mBar pressure. During the pre-lamination step both the glass fiber sheet and the encapsulant sheet were stacked between two teflon coated release sheets. After pre-lamination the tefon coated release sheets were removed (peeled off). The pre-lamination heating step induced liquefication of the encapsulant material and impregnation of the glass fiber sheet with the 'type A' encapsulant material, resulting in a fiber reinforced encapsulant sheet (composite sheet, pre-laminated sheet). The composite sheets thus formed had a total thickness of about 425 micrometer and a glass fiber filling degree of about 8.5 wt% when using a single encapsulant sheet. When using two encapsulant sheets (one at each side of the glass fiber sheet, i.e. using an encapsulant sheet / glass fiber sheet / encapsulant sheet stack) in the pre-lamination process, the composite sheet (fiber reinforced encapsulant sheet) had a total thickness of about 823 micrometer. Contact sheets were formed by stitching twenty SnBi coated copper wires (200 micrometer diameter) through the pre-laminated encapsulant/fiber sheets thus obtained. The electrically conductive wires were provided substantially parallel to each other, with a distance between neighbouring wires in the order of 7 mm to 8 mm. This second type of contact sheets is further referred to as a pre-laminated composite sheet.

The resulting contact sheets (size 20 cm x 20 cm) were brought into physical contact with a surface of a bifacial photovoltaic cell (cell size 15.6 cm x 15.6 cm) comprising a plurality of metal contacts, with electrically conductive wires of the contact sheet aligned to metal contacts of the cells. This was done at both sides (both surfaces) of the bifacial cell, as schematically illustrated in FIG 6. The bifacial cell was a busbar-free cell with metal contacts consisting of contact fingers printed on both cell surfaces. Next, as a transparent carrier, a 20 cm x 20 cm glass plate was provided over the contact sheet, at both sides of the cell, as schematically illustrated in FIG 6. The resulting stack (first glass plate 30₁ / first contact sheet 10₁ (with bussing ribbon) / bifacial photovoltaic cell 20 / second contact sheet 10₂ (with bussing ribbon) / second glass plate 30₂) was subjected to a lamination step comprising heating to 165°C, using an 11 minutes compression step at 350 mbar.

Encapsulated and electrically contacted bifacial cells were made using the different types of contact sheets as described above. Further, as a reference, an encapsulated and electrically contacted bifacial cell was made, using a 'type A' encapsulant sheet without glass fibers.

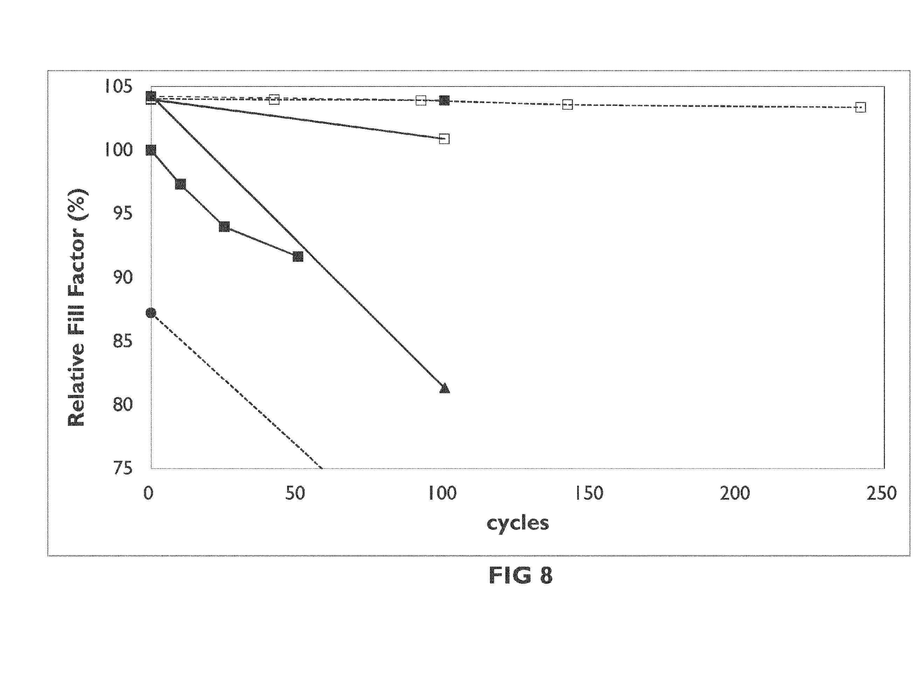

The different samples were subjected to thermal cycling tests, according to IEC 61215 and IEC 61646 standards, comprising thermal cycling between -40°C and +80°C. Results of these tests are shown in FIG 8, showing the relative fill factor (FF) as measured as a function of the number of thermal cycles performed. Square symbols represent results obtained using 'type A' encapsulation material (filled squares with full line: reference sample without glass fiber; open squares with full line: sample with non-pre-laminated sheet (first approach described above); open squares with dashed line: pre-laminated composite with single encapsulant sheet; filled squares with dashed line: pre-laminated composite with two encapsulant sheets). Triangles represent results for 'type B' encapsulant material and circles represent results for EVA encapsulant material (both types of contact sheets being made according to the first approach described above).

From the thermal cycling results (FIG 8), it can be concluded that the initial FF performance for the pre-laminated composite sheet samples and for the non-pre-laminated contact sheet with 'type A' encapsulant material is about 5% (relative) better than for the reference sample without glass fiber. It can further be concluded that FF degradation under thermal cycling is within a 5% limit after 100 cycles for these samples. After 250 cycles a maximum degradation of 1.64% (relative) is observed for the pre-laminated composite samples, and even at 400 cycles their degradation is still within the 5% relative FF degradation limit. Samples with non-prelaminated contact sheets based on 'type B' encapsulant material and based on EVA encapsulant material, as well as the reference sample show a degradation of the fill factor higher than 5% (relative) after less than 25 thermal cycles.

Additional experiments were performed wherein a method according to the present invention was applied for electrically contacting and encapsulating back-contact cells, using a woven fabric encapsulant sheet comprising a type A encapsulant material. The encapsulant material was provided in the form of a plurality of electrically insulating ribbons. A plurality of electrically conductive wires, more in particular a plurality of SnBi coated ribbons, was interwoven with the electrically insulating encapsulant ribbons. Contact sheets were formed by by pre-laminating the woven fabric encapsulant sheet with a glass fiber sheet comprising chopped glass fibers. As a reference, similar contact sheets were made without fiber material.

Based on SEM images it was observed that the samples that were made in accordance with the present invention, wherein a glass fiber material was incorporated in the contact sheet, show a substantially improved solder distribution as compared to the samples without glass fiber material. Moreover, a reduced solder flow and a better alignment between the electrically conductive ribbons of the contact sheet and the metal contacts of the photovoltaic cells was observed in samples comprising fiber material as compared to the reference samples without fiber material.

The foregoing description details certain embodiments of the invention. It will be appreciated, however, that no matter how detailed the foregoing appears in text, the invention may be practiced in many ways.

It is to be understood that although preferred embodiments, specific constructions and configurations, as well as materials, have been discussed herein, various changes or modifications in form and detail may be made without departing from the scope of this invention.

## Claims

1. A method (100, 200) for electrically contacting at least one photovoltaic cell (20, 20₁, 20₂) comprising at least one metal contact (21, 21₁, 21₂) at a surface (22, 22₁, 22₂) of the at least one photovoltaic cell (20, 20₁, 20₂), the method comprising:
bringing (101, 201, 202) a contact sheet (10, 10₁, 10₂) comprising an electrically insulating encapsulant material (11) and a plurality of electrically conductive wires (12) covered by or coated with a solderable material into physical contact with the surface (22, 22₁, 22₂) of the at least one photovoltaic cell (20, 20₁, 20₂),
the electrically insulating encapsulant material (11) being a thermoplastic material;
covering (102, 203) the contact sheet (10, 10₁, 10₂) with a carrier (30, 30₁, 30₂), at a side of the contact sheet (10, 10₁, 10₂) opposite to the side where it is in contact with the surface (22, 22₁, 22₂) of the at least one photovoltaic cell (20, 20₁, 20₂);
afterwards performing (103, 204) a heating process, thereby:
establishing an electrical connection between at least one metal contact (21, 21₁, 21₂) at the surface (22, 22₁, 22₂) of the at least one photovoltaic cell (20, 20₁, 20₂) and at least one electrically conductive wire (12) of the contact sheet (10, 10₁, 10₂) by soldering;
liquefying the electrically insulating encapsulant material (11);
attaching the carrier (30, 30₁, 30₂) to the contact sheet (10, 10₁, 10₂), by adhesion of the electrically insulating encapsulant material (11) to the carrier (30, 30₁, 30₂); and
attaching the contact sheet (10, 10₁, 10₂) to the surface (22, 22₁, 22₂) of the at least one photovoltaic cell (20, 20₁, 20₂), by adhesion of the electrically insulating encapsulant material (11) to the surface (22, 22₁, 22₂) of the at least one photovoltaic cell (20, 20₁, 20₂),
thereby forming a laminate comprising a stack comprising the at least one photovoltaic cell (20, 20₁, 20₂), the contact sheet (10, 10₁, 10₂) and the carrier (30, 30₁, 30₂);
and wherein the contact sheet (10, 10₁, 10₂) comprises a fiber material (13) incorporated between the at least one photovoltaic cell (20, 20₁, 20₂) and the carrier (30, 30₁, 30₂).

2. The method (100, 200) for electrically contacting at least one photovoltaic cell (20, 20₁, 20₂) according to claim 1, wherein the fiber material (13) is embedded in the electrically insulating encapsulant material (11).

3. The method (100, 200) for electrically contacting at least one photovoltaic cell (20, 20₁, 20₂) according to claim 1, wherein the fiber material (13) is laminated with the electrically insulating encapsulant material (11).

4. The method (100, 200) for electrically contacting at least one photovoltaic cell (20, 20₁, 20₂) according to any of the previous claims, wherein the electrically insulating encapsulant material (11) comprises a plurality of electrically insulating wires, and wherein the plurality of electrically insulating wires are interwoven with the plurality of electrically conductive wires (12).

5. The method (100, 200) for electrically contacting at least one photovoltaic cell (20, 20₁, 20₂) according to any of claims 1 to 3, wherein the electrically insulating encapsulant material (11) comprises an encapsulant sheet, and wherein the plurality of electrically conductive wires (13) is attached to or integrated with the encapsulant sheet by printing, stitching, sewing or heating.

6. The method (100, 200) for electrically contacting at least one photovoltaic cell (20, 20₁, 20₂) according to any of the previous claims, wherein the fiber material (13) comprises a plurality of chopped fibers.

7. The method (100, 200) for electrically contacting at least one photovoltaic cell (20, 20₁, 20₂) according to any of the previous claims, wherein the fiber material (13) comprises a glass fiber material, a basalt fiber material or a natural fiber material.

8. The method (100, 200) for electrically contacting at least one photovoltaic cell (20, 20₁, 20₂) according to any of the previous claims, wherein the carrier (30, 30₁, 30₂) is a glass plate, a quartz plate, a polyvinyl fluoride foil, a polyethylene terephthalate foil or a polycarbonate foil.

9. The method (100, 200) for electrically contacting at least one photovoltaic cell (20, 20₁, 20₂) according to any of the previous claims,
wherein bringing the contact sheet (10, 10₁, 10₂) into physical contact with the surface (22₁, 22₂) of the at least one photovoltaic cell (20₁, 20₂) comprises bringing (201) a first part (1) of the contact sheet (10, 10₁, 10₂) into physical contact with the surface (22₁) of a first photovoltaic cell (20₁) and bringing (202) a second part (2) of the contact sheet (10, 10₁, 10₂) into physical contact with the surface (22₂) of a second photovoltaic cell (20₂),
wherein, when performing (204) the heating process, at least one first metal contact (21₁) at the surface (22₁) of the first photovoltaic cell (20₁) and at least one second metal contact (21₂) at the surface (22₂) of the second photovoltaic cell (20₂) are electrically connected to a same electrically conductive wire (12) of the contact sheet (10, 10₁, 10₂), thereby further electrically connecting the first photovoltaic cell (20₁) with the second photovoltaic cell (20₂) by means of said same electrically conductive wire (12), and
thereby forming a structure comprising encapsulated, electrically contacted and electrically connected first and second photovoltaic cells (20₁, 20₂) side by side.

10. A method for fabricating a photovoltaic module comprising a plurality of photovoltaic cells (20, 20₁, 20₂), the method comprising electrically contacting at least one photovoltaic cell (20, 20₁, 20₂) of the plurality of photovoltaic cells using the method according to claim 9.

## Patentansprüche

1. Verfahren (100, 200) zum elektrischen Kontaktieren mindestens einer Photovoltaikzelle (20, 20₁, 20₂), die mindestens einen Metallkontakt (21, 21₁, 21₂) an einer Oberfläche (22, 22₁, 22₂) der mindestens einen Photovoltaikzelle (20, 20₁, 20₂) umfasst, wobei das Verfahren umfasst:
physisches In-Kontakt-Bringen (101, 201, 20₂) eines Kontaktblechs (10, 10₁, 10₂), die ein elektrisch isolierendes Einkapselungsmaterial (11) und eine Vielzahl von elektrisch leitenden Drähten (12) umfasst, die mit einem lötbaren Material bedeckt oder beschichtet sind, mit der Oberfläche (22, 22₁, 22₂) der mindestens einen Photovoltaikzelle (20, 20₁, 20₂),
wobei das elektrisch isolierende Einkapselungsmaterial (11) ein thermoplastisches Material ist;
Bedecken (102, 203) des Kontaktblechs (10, 10₁, 10₂) mit einem Träger (30, 30₁, 30₂) auf einer Seite des Kontaktblechs (10, 10₁, 10₂) gegenüber der Seite, auf der es mit der Oberfläche (22, 22₁, 22₂) der mindestens einen Photovoltaikzelle (20, 20₁, 20₂₎in Kontakt steht;
danach Durchführen (103, 204) eines Heizprozesses, dadurch:
Aufbauen einer elektrischen Verbindung zwischen mindestens einem Metallkontakt (21, 21₁, 21₂) an der Oberfläche (22, 22₁, 22₂) der mindestens einen Photovoltaikzelle (20, 20₁, 20₂) und mindestens einem elektrisch leitfähigen Draht (12) des Kontaktblechs (10, 10₁, 10₂) durch Löten;
Verflüssigen des elektrisch isolierendes Einkapselungsmaterials (11);
Anbringen des Trägers (30, 30₁, 30₂) am Kontaktblech (10, 10₁, 10₂) durch Kleben des elektrisch isolierenden Einkapselungsmaterials (11) an dem Träger (30, 30₁, 30₂); und
Anbringen des Kontaktblechs (10, 10₁, 10₂) an der Oberfläche (22, 22₁, 22₂) der mindestens einen Photovoltaikzelle (20, 20₁, 20₂) durch Kleben des elektrisch isolierenden Einkapselungsmaterials (11) an der Oberfläche (22, 22₁, 22₂) der mindestens einen Photovoltaikzelle (20, 20₁, 20₂),
dadurch Bilden eines Laminats, das einen Stapel umfasst, der die mindestens eine Photovoltaikzelle (20, 20₁, 20₂), das Kontaktblech (10, 10₁, 10₂) und den Träger (30, 30₁, 30₂) umfasst;
und wobei das Kontaktblech (10, 10₁, 10₂) ein Fasermaterial (13) umfasst, das zwischen der mindestens einen Photovoltaikzelle (20, 20₁, 20₂) und dem Träger (30, 30₁, 30₂) eingesetzt ist.

2. Verfahren (100, 200) zum elektrischen Kontaktieren mindestens einer Photovoltaikzelle (20, 20₁, 20₂) nach Anspruch 1, wobei das Fasermaterial (13) in das elektrisch isolierende Einkapselungsmaterial (11) eingebettet ist.

3. Verfahren (100, 200) zum elektrischen Kontaktieren mindestens einer Photovoltaikzelle (20, 20₁, 20₂) nach Anspruch 1, wobei das Fasermaterial (13) mit dem elektrisch isolierenden Einkapselungsmaterial (11) laminiert wird.

4. Verfahren (100, 200) zum elektrischen Kontaktieren mindestens einer Photovoltaikzelle (20, 20₁, 20₂) nach einem der vorstehenden Ansprüche, wobei das elektrisch isolierende Einkapselungsmaterial (11) eine Vielzahl von elektrisch isolierenden Drähten umfasst, und wobei die Vielzahl von elektrisch isolierenden Drähten mit der Vielzahl von elektrisch leitfähigen Drähten (12) verwebt ist.

5. Verfahren (100, 200) zum elektrischen Kontaktieren mindestens einer Photovoltaikzelle (20, 20₁, 20₂) nach einem der Ansprüche 1 bis 3, wobei das elektrisch isolierende Einkapselungsmaterial (11) ein Einkapselungsblech umfasst, und wobei die Vielzahl von elektrisch leitfähigen Drähten (13) durch Drucken, Heften, Nähen oder Erhitzen an dem Einkapselungsblech angebracht oder darin integriert wird.

6. Verfahren (100, 200) zum elektrischen Kontaktieren mindestens einer Photovoltaikzelle (20, 20₁, 20₂) nach einem der vorstehenden Ansprüche, wobei das Fasermaterial (13) eine Vielzahl gehackter Fasern umfasst.

7. Verfahren (100, 200) zum elektrischen Kontaktieren mindestens einer Photovoltaikzelle (20, 20₁, 20₂) nach einem der vorstehenden Ansprüche, wobei das Fasermaterial (13) ein Glasfasermaterial, ein Basaltfasermaterial oder ein Naturfasermaterial umfasst.

8. Verfahren (100, 200) zum elektrischen Kontaktieren mindestens einer Photovoltaikzelle (20, 20₁, 20₂) nach einem der vorstehenden Ansprüche, wobei der Träger (30, 30₁, 30₂) eine Glasplatte, eine Quarzplatte, eine Polyvinylfluoridfolie, eine Polyethylenterephthalatfolie oder eine Polycarbonatfolie ist.

9. Verfahren (100, 200) zum elektrischen Kontaktieren mindestens einer Photovoltaikzelle (20, 20₁, 20₂) nach einem der vorstehenden Ansprüche,
wobei das physische In-Kontakt-Bringen des Kontaktblechs (10, 10₁, 10₂) mit der Oberfläche (22₁, 22₂) der mindestens einen Photovoltaikzelle (20₁, 20₂) das physische In-Kontakt-Bringen (201) eines ersten Teils (1) des Kontaktblechs (10, 10₁, 10₂) mit der Oberfläche (22₁) einer ersten Photovoltaikzelle (20₁) und das physische In-Kontakt-Bringen (20₂) eines zweiten Teils (2) des Kontaktblechs (10, 10₁, 10₂) mit der Oberfläche (22₂) einer zweiten Photovoltaikzelle (20₂) umfasst, wobei beim Durchführen (204) des Heizprozesses mindestens ein erster Metallkontakt (21₁) an der Oberfläche (22₁) der ersten Photovoltaikzelle (20₁) und mindestens ein zweiter Metallkontakt (21₂) an der Oberfläche (22₂) der zweiten Photovoltaikzelle (20₂) elektrisch mit einem gleichen elektrisch leitenden Draht (12) des Kontaktblechs (10, 10₁, 10₂) verbunden sind, wodurch die erste Photovoltaikzelle (20₁) weiter mit der zweiten Photovoltaikzelle (20₂) mittels desselben elektrisch leitenden Drahts (12) elektrisch verbunden wird und dadurch eine Struktur gebildet wird, welche die eingekapselte, elektrisch kontaktierte und elektrisch verbundene erste und zweite Photovoltaikzellen (20₁, 20₂) Seite an Seite umfasst.

10. Verfahren zum Herstellen eines Photovoltaikmoduls, das eine Vielzahl von Photovoltaikzellen (20, 20₁, 20₂) umfasst, wobei das Verfahren elektrisches Kontaktieren mindestens einer Photovoltaikzelle (20, 20₁, 20₂) der Vielzahl von Photovoltaikzellen unter Verwendung des Verfahrens nach Anspruch 9 umfasst.

## Revendications

1. Procédé (100, 200) pour mettre électriquement en contact au moins une cellule photovoltaïque (20, 20₁, 20₂) comprenant au moins un contact métallique (21, 21₁, 21₂) au niveau d'une surface (22, 22₁, 22₂) de la au moins une cellule photovoltaïque (20, 20₁, 20₂), le procédé comprenant :
la mise (101, 201, 20₂) en contact physique d'une feuille de contact (10, 10₁, 10₂) comprenant un matériau d'encapsulation électro-isolant (11) et une pluralité de fils électroconducteurs (12) recouverts, ou revêtus, d'un matériau soudable avec la surface (22, 22₁, 22₂) de la au moins une cellule photovoltaïque (20, 20₁, 20₂),
le matériau d'encapsulation électro-isolant (11) étant un matériau thermoplastique ;
le recouvrement (102, 203) de la feuille de contact (10, 10₁, 10₂) avec un support (30, 30₁, 30₂), sur un côté de la feuille de contact (10, 10₁, 10₂) opposé au côté où elle est en contact avec la surface (22, 22₁, 22₂) de la au moins une cellule photovoltaïque (20, 20₁, 20₂) ;
ensuite l'exécution (103, 204) d'un processus de chauffage, ainsi :
l'établissement d'un raccordement électrique entre au moins un contact métallique (21, 21₁, 21₂) au niveau de la surface (22, 22₁, 22₂) de la au moins une cellule photovoltaïque (20, 20₁, 20₂) et au moins un fil électroconducteur (12) de la feuille de contact (10, 10₁, 10₂) par soudage ;
la liquéfaction du matériau d'encapsulation électro-isolant (11) ;
la fixation du support (30, 30₁, 30₂) à la feuille de contact (10, 10₁, 10₂), par adhérence du matériau d'encapsulation électro-isolant (11) au support (30, 30₁, 30₂) ; et
la fixation de la feuille de contact (10, 10₁, 10₂) à la surface (22, 22₁, 22₂) de la au moins une cellule photovoltaïque (20, 20₁, 20₂), par adhérence du matériau d'encapsulation électro-isolant (11) à la surface (22, 22₁, 22₂) de la au moins une cellule photovoltaïque (20, 20₁, 20₂),
ce qui permet de former un stratifié comprenant un empilement comprenant la au moins une cellule photovoltaïque (20, 20₁, 20₂), la feuille de contact (10, 10₁, 10₂) et le support (30, 30₁, 30₂) ;
et dans lequel la feuille de contact (10, 10₁, 10₂) comprend un matériau fibreux (13) incorporé entre la au moins une cellule photovoltaïque (20, 20₁, 20₂) et le support (30, 30₁, 30₂).

2. Procédé (100, 200) pour mettre électriquement en contact au moins une cellule photovoltaïque (20, 20₁, 20₂) selon la revendication 1, dans lequel le matériau fibreux (13) est noyé dans le matériau d'encapsulation électro-isolant (11).

3. Procédé (100, 200) pour mettre électriquement en contact au moins une cellule photovoltaïque (20, 20₁, 20₂) selon la revendication 1, dans lequel le matériau fibreux (13) est stratifié avec le matériau d'encapsulation électro-isolant (11).

4. Procédé (100, 200) pour mettre électriquement en contact au moins une cellule photovoltaïque (20, 20₁, 20₂) selon l'une quelconque des revendications précédentes, dans lequel le matériau d'encapsulation électro-isolant (11) comprend une pluralité de fils électro-isolants et dans lequel la pluralité de fils électro-isolants sont entrelacés avec la pluralité de fils électroconducteurs (12).

5. Procédé (100, 200) pour mettre électriquement en contact au moins une cellule photovoltaïque (20, 20₁, 20₂) selon l'une quelconque des revendications 1 à 3, dans lequel le matériau d'encapsulation électro-isolant (11) comprend une feuille d'encapsulation et dans lequel la pluralité de fils électroconducteurs (13) est fixée, ou intégrée, à la feuille d'encapsulation par impression, piqûre, couture ou chauffage.

6. Procédé (100, 200) pour mettre électriquement en contact au moins une cellule photovoltaïque (20, 20₁, 20₂) selon l'une quelconque des revendications précédentes, dans lequel le matériau fibreux (13) comprend une pluralité de fibres coupées.

7. Procédé (100, 200) pour mettre électriquement en contact au moins une cellule photovoltaïque (20, 20₁, 20₂) selon l'une quelconque des revendications précédentes, dans lequel le matériau fibreux (13) comprend un matériau de fibre de verre, un matériau de fibre de basalte ou un matériau de fibre naturelle.

8. Procédé (100, 200) pour mettre électriquement en contact au moins une cellule photovoltaïque (20, 20₁, 20₂) selon l'une quelconque des revendications précédentes, dans lequel le support (30, 30₁, 30₂) est une plaque de verre, une plaque de quartz, une feuille de fluorure de polyvinyle, une feuille de téréphtalate de polyéthylène ou une feuille de polycarbonate.

9. Procédé (100, 200) pour mettre électriquement en contact au moins une cellule photovoltaïque (20, 20₁, 20₂) selon l'une quelconque des revendications précédentes,
dans lequel la mise en contact physique de la feuille de contact (10, 10₁, 10₂) avec la surface (22₁, 22₂) de la au moins une cellule photovoltaïque (20₁, 20₂) comprend la mise (201) en contact physique d'une première partie (1) de la feuille de contact (10, 10₁, 10₂) avec la surface (22₁) d'une première cellule photovoltaïque (20₁) et la mise (20₂) en contact physique d'une seconde partie (2) de la feuille de contact (10, 10₁, 10₂) avec la surface (22₂) d'une seconde cellule photovoltaïque (20₂), dans lequel, lors de la réalisation (204) du processus de chauffage, au moins un premier contact métallique (21₁) au niveau de la surface (22₁) de la première cellule photovoltaïque (20₁) et au moins un second contact métallique (21₂) au niveau de la surface (22₂) de la seconde cellule photovoltaïque (20₂) sont raccordés électriquement à un même fil électroconducteur (12) de la feuille de contact (10, 10₁, 10₂), ce qui permet en outre de raccorder électriquement la première cellule photovoltaïque (20₁) à la seconde cellule photovoltaïque (20₂) au moyen dudit même fil électroconducteur (12), et ce qui permet de former une structure comprenant des première et seconde cellules photovoltaïques (20₁, 20₂) encapsulées, en contact électrique et raccordées électriquement côte à côte.

10. Procédé pour fabriquer un module photovoltaïque comprenant une pluralité de cellules photovoltaïques (20, 20₁, 20₂), le procédé comprenant la mise en contact électrique d'au moins une cellule photovoltaïque (20, 20₁, 20₂) de la pluralité de cellules photovoltaïques à l'aide du procédé selon la revendication 9.
